(19) Europäisches Patentamt

European Patent Office

Office européen des brevets

(11) EP 1 567 873 B1

(12) **EUROPEAN PATENT SPECIFICATION**

(45) Date of publication and mention
of the grant of the patent:
**10.05.2006 Bulletin 2006/19**

(51) Int Cl.:
**G01R 31/06** (2006.01)    **G01R 31/34** (2006.01)

(21) Application number: **03774380.4**

(22) Date of filing: **14.11.2003**

(86) International application number:
**PCT/NL2003/000801**

(87) International publication number:
**WO 2004/051291 (17.06.2004 Gazette 2004/25)**

(54) **METHOD AND APPARATUS FOR LOCATING A DISCHARGE IN A STATOR OF AN ELECTRICAL MACHINE**

VERFAHREN UND VORRICHTUNG ZUR LOKALISIERUNG EINER ENTLADUNG IN EINEM STATOR EINER ELEKTRISCHEN MASCHINE

PROCEDE ET APPAREIL POUR LA LOCALISATION D'UNE DECHARGE DANS UN STATOR D'UNE MACHINE ELECTRIQUE

(84) Designated Contracting States:
**AT BE BG CH CY CZ DE DK EE ES FI FR GB GR HU IE IT LI LU MC NL PT RO SE SI SK TR**

(30) Priority: **29.11.2002 NL 1022026**

(43) Date of publication of application:
**31.08.2005 Bulletin 2005/35**

(73) Proprietors:
• **Technische Universiteit Delft**
  **2628 BL Delft (NL)**
• **N.V. Kema**
  **6812 AR Arnhem (NL)**

(72) Inventor: **VAN BREEN, Harry, Jorn**
**NL-2628 DT Delft (NL)**

(74) Representative: **Van Breda, Jacobus**
**Octrooibureau Los en Stigter B.V.,**
**Weteringschans 96**
**1017 XS Amsterdam (NL)**

(56) References cited:
**US-B1- 6 452 416**

• **VAN BREEN H J ET AL: "Localizing the source of partial discharges in large generators" PROCEEDINGS OF THE INTERNATIONAL CONFERENCE ON PROPERTIES AND APPLICATIONS OF DIELECTRIC MATERIALS, vol. 2, 21 June 2000 (2000-06-21), - 26 June 2000 (2000-06-26) pages 868-871, XP010516222 cited in the application**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

The invention relates to a method for locating a source of discharge of at least one partial discharge in a stator of an electrical machine, wherein the stator is on various positions provided with sensors for detecting electric pulses generated by the discharge, whereby at least one time delay is determined between the electrical pulses detected by the sensors, and based on this at least one time delay the location of the source of discharge is calculated.

Such a method is known from the article "Localising the Source of Partial Discharges in Large Generators" by H.J. van Breen, E. Gulski and J.J. Smit, published in "The Proceedings of the Sixth International Conference on Properties and Applications of Dielectric Materials"; published in 2000.

In this known method four recorders are placed on the stator of a generator, and from these separate sensors time delay signals are measured and used to detect the location in the electrical machine, where a discharge has taken place.

As already known, an electrical machine in the form of a generator or a motor comprises a rotating part, the rotator; and a stationary part, the stator. The stator has a plurality of coils, which during operation carry a high voltage, usually between 10 and 20 kilovolt. Between the coils a high-voltage insulation is incorporated in the form of, for example, MiCa. A characteristic of this insulation is that it comprises small cavities, which develop during fabrication. When the electrical machine is in operation, sparks develop in the cavities of the insulation. These sparks, also called discharges, are dependent on the size of the cavities in the insulating material.

The object of the invention is to provide a method and apparatus with which it is possible in a simple manner to map the discharge behaviour of an electrical machine. The discharge behaviour, and in particular the number of discharges taking place in the insulation, appears to be a good indication of the insulation's ageing. In this way any defects in the insulation can be detected in good time, so that repair can be carried out before the ageing causes short circuiting. In this way the expenses resulting from unexpected short circuiting can be avoided. Such expenses include among others the costs of the prolonged stoppage resulting from the extensive repair that has become necessary due to the short circuiting.

The method and apparatus proposed in accordance with the invention comprises various aspects, which are expressed in the appended claims.

In a first aspect of the invention, the method is characterised in that the calculated location of the source of discharge is carried out by optimising a differential function to a minimum value:

$$e = \sqrt{\sum_{s=A}^{G} a_s \cdot (\Delta Tm_s - \Delta Tc_s)^2}$$

wherein the variables used have the following meaning:
e = result of differential function
s = sensor A, B, C, D, E, F or G
As = measured amplitude of electrical pulse at sensor s
$\Delta$ Tms = measured time delay at sensor s in relation to a reference
$\Delta$ Tcs = computed time delay at sensor s in relation to the reference
and that the computed time delay $\Delta$ Tcs is determined for different selected calculated locations of the discharge, and the selected calculated location producing the lowest differential function value is designated as the source of discharge. The use of such a relatively simple method has made an adequate calculation of the source of discharge possible.

It has been shown to be advantageous to compute the time delay $\Delta$ Tcs using the formula:

$$T_s = \sqrt{\left(\frac{dist(x_p, x_s)}{v_x}\right)^2 + \left(\frac{dist(y_p, y_s)}{v_y}\right)^2} + C$$

wherein the variables used have the following meaning:
dist (xp, xs) = distance in tangential direction x of the stator between the source of discharge (xp, yp) and location (xs, ys) of sensor s

dist (yp, ys) = distance in axial direction y of the stator between the source of discharge (xp, yp) and location (xs, ys) of sensor s

Vx = propagation velocity electrical pulse in tangential direction x

Vy = propagation velocity electrical pulse in axial direction y

C = correction constant;

wherein xp and yp are freely selectable variables relating to the source of discharge.

Surprisingly, in order to effectively and accurately determine the source of discharge, it is desirable when computing the time delay $\Delta Tcs$ for various selected calculated locations (xp, yp) of discharge, to also use the propagation velocity Vx in tangential direction of the stator, and the propagation velocity Vy in axial direction of the stator as freely selectable variables.

In accordance with the invention this is based on the principle that it is of vital importance to determine the time of arrival of the detected signals at the sensors. This is related to the variable velocity of the electrical pulses, which depends on their frequency. High frequencies (more than 10 Mhz) propagate at velocities of approximately 10 to 20% of the speed of light, while low-frequency signals (less than 5 Mhz) propagate at a velocity of approximately 3 to 4% of the speed of light.

In order to limit the measuring sensitivity with respect to these velocity differences, it is in a further aspect of the invention advantageous to connect a band-pass filter with each of the sensors, so as to condition the electrical pulses detected by the sensors.

Advisably, the band-pass filter is adjusted at a central frequency of approximately 1.2 Mhz and a band width of approximately 2 Mhz.

As already mentioned above, the invention is also embodied in an apparatus for locating a source of discharge of at least one partial discharge in a stator of an electrical machine, comprising sensors distributed over the stator for the detection of electrical pulses generated by the discharge, and characterised in that the same possesses a comparator for determining a time delay between the electrical pulses detected by the sensors, wherein an arithmetic unit is provided that co-operates with the comparator, and both together are equipped to carry out the method explained above.

This apparatus is preferably embodied such that a band-pass filter is connected to each of these sensors for conditioning the electrical pulses detected by the sensors.

As already mentioned above, it is advisable for the band-pass filter to have a central frequency of approximately 1.2 Mhz and a band width of approximately 2 Mhz.

The invention is further embodied in software, optionally on a carrier, and when loaded in a computer that forms part of the above-discussed apparatus, suitable for carrying out the method explained above. The computer thus loaded with such software controls the operation of the above-mentioned comparator and arithmetic unit for carrying out the method as explained.

Finally, exclusive rights are also asked for a generator for generating electric energy and an electrical motor, which machines both comprise a generally known rotor and stator, and which are characterised in that an apparatus as explained above is connected to the stator.

Hereinafter the invention will be further explained with reference to a non-limiting exemplary embodiment and with reference to a number of figures.

Fig. 1 shows a stator of a generator, wherein arrows indicate possible positions for sensors.

Fig. 2 shows a schematic illustration of the stator core, wherein the horizontal x-direction corresponds to the tangential direction of the stator, and the vertical y-direction corresponds to the axial direction of the stator.

Fig. 3 shows detected electrical pulses on the sensors before and after passing a band-pass filter.

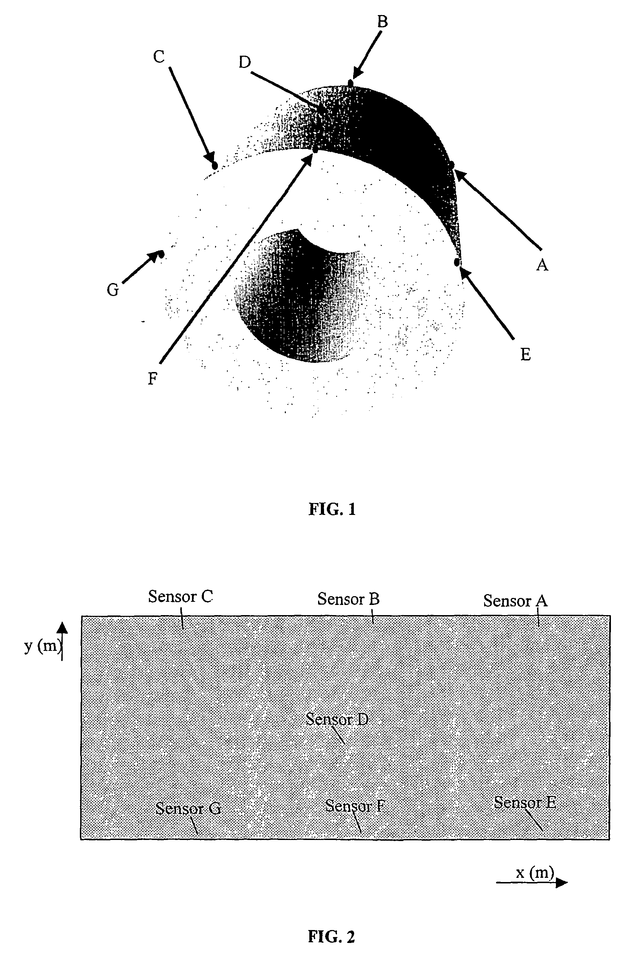

During operation, electrical pulses are detected by means of sensors provided at the positions A to G as shown in Fig. 1, while their phase relationship is used to locate the source of discharge of at least one partial discharge occurring in the stator of the electrical machine.

The manner in which location of the source of discharge is realised may be further usefully elucidated by referring to Fig. 2.

The location of the source of discharge is calculated by optimally minimising the value of a differential function:

$$e = \sqrt{\sum_{s=A}^{G} a_s \cdot (\Delta Tm_s - \Delta Tc_s)^2}$$

wherein the variables used have the following meaning:

e = result of differential function

s = sensor A, B, C, D, E, F or G

As = measured amplitude of electrical pulse at sensor s

$\Delta$ Tms = measured time delay at sensor s in relation to a reference

$\Delta$ Tcs = computed time delay at sensor s with respect of the reference

and that the computed time delay $\Delta$ Tcs is determined for different selected calculated locations of the discharge, and the selected calculated location producing the lowest differential function value is designated as the source of discharge.

Computation of the time delay $\Delta$ Tcs is performed using the formula:

$$T_v = \sqrt{\left(\frac{dist(x_p, x_s)}{v_x}\right)^2 + \left(\frac{dist(y_p, y_s)}{v_y}\right)^2} + C$$

wherein the variables used have the following meaning:

dist (xp, xs) = distance in tangential direction x of the stator between the source of discharge (xp, yp) and location (xs, ys) of sensor s

dist (yp, ys) = distance in axial direction y of the stator between the source of discharge (xp, yp) and location (xs, ys) of sensor s

Vx = propagation velocity electrical pulse in tangential direction x

Vy = propagation velocity electrical pulse in axial direction y

C = correction constant;

wherein xp and yp are freely selectable variables relating to the source of discharge.

In a particular preferred embodiment of the invention, the computation of the time delay $\Delta$ Tcs for various selected calculated locations (xp, yp) of the discharge may also make use of the propagation velocity Vx in tangential direction of the stator, and the propagation velocity Vy in axial direction of the stator as freely selectable variables.

Incidentally, it should be noted that the above-mentioned amplitude axis of the electrical pulse measured at sensor s, imparts a relative value to the electrical pulses detected by the sensors A to G. This measured amplitude axis represents signals having a high signal/noise ratio as more relevant than signals having a low signal/noise ratio.

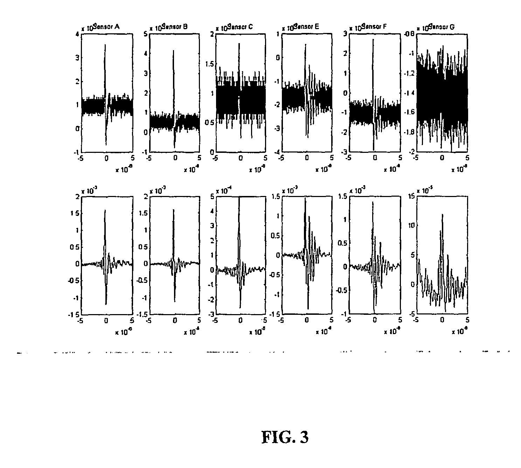

Fig. 3 shows the effect of using a band-pass filter on the sensors, whereby the detected electrical pulses are conditioned by this band-pass filter. The band-pass filter used in the present example is adjusted at a central frequency of approximately 1.2 Mhz and a band width of approximately 2 Mhz.

The top row in Fig. 3 shows for each of the sensors A to G the unfiltered signal detected by the respective sensor, and in the bottom row the pulse signal from that sensor after passing the band-pass filter, which as mentioned, is the preferred signal to be used in the method according to the invention. The first peak in the filtered pulse signal is used to determine the pulse's arrival time at the sensor. The amplitude axis relates to the maximum value of this pulse signal.

The invention allows for several variations, without departing from the protective scope of the appended claims. For example, the signal/noise ratio of the detected signals can be improved by using wavelets preceding the proposed band-pass filter.

It must therefore be understood, that the above-given explanation does not limit the appended claims. The discussed exemplary embodiment merely serves to elucidate the appended claims, without limiting them in any way.

**Claims**

1. A method for locating a source of discharge of at least one partial discharge in a stator of an electrical machine, wherein the stator is provided on various positions with sensors for detecting electric pulses generated by the discharge, whereby at least one time delay is determined between the electrical pulses detected by the sensors, and based on this at least one time delay the location of the source of discharge is calculated, **characterised in that** the calculated location of the source of discharge is carried out by optimising a differential function to a minimum value:

$$e = \sqrt{\sum_{s=A}^{G} a_s \cdot (\Delta Tm_s - \Delta Tc_s)^2}$$

wherein the variables used have the following meaning:

e = result of differential function

s = sensor A, B, C, D, E, F or G

As = measured amplitude of electrical pulse at sensor s

$\Delta$ Tms = measured time delay at sensor s in relation to a reference

$\Delta$ Tcs = computed time delay at sensor s in relation to the reference

and that the computed time delay $\Delta$ Tcs is determined for different selected calculated locations of the discharge, and the selected calculated location producing the lowest differential function value is designated as the source of discharge.

2.  A method according to claim 1, **characterised in that** the time delay $\Delta$ Tcs is computed using the formula:

$$T_s = \sqrt{\left(\frac{dist(x_p, x_s)}{v_x}\right)^2 + \left(\frac{dist(y_p, y_s)}{v_y}\right)^2} + C$$

wherein the variables used have the following meaning:

dist (xp, xs) = distance in tangential direction x of the stator between the source of discharge (xp, yp) and location (xs, ys) of sensor s

dist (yp, ys) = distance in axial direction y of the stator between the source of discharge (xp, yp) and location (xs, ys) of sensor s

Vx = propagation velocity electrical pulse in tangential direction x

Vy = propagation velocity electrical pulse in axial direction y

C = correction constant;

wherein xp and yp are freely selectable variables relating to the source of discharge.

3.  A method according to claim 1 or 2, **characterised in that** when computing the time delay $\Delta$ Tcs for various selected calculated locations (xp, yp) of discharge, use is also made of the propagation velocity Vx in tangential direction of the stator, and the propagation velocity Vy in axial direction of the stator as freely selectable variables.

4.  A method according to one of the preceding claims, **characterised in that** a band-pass filter is connected with each of the sensors, to condition the electrical pulses detected by the sensors.

5.  A method according to claim 4, **characterised in that** the band-pass filter is adjusted at a central frequency of approximately 1.2 Mhz and a band width of approximately 2 Mhz.

6.  Software, optionally on a carrier, for carrying out the method in accordance with one of the claims 1-5.

7.  An apparatus for locating a source of discharge of at least one partial discharge in a stator of an electrical machine, wherein the stator is provided on various positions with sensors for detecting electric pulses generated by the discharge, **characterised in that** the same possesses a comparator for determining a time delay between the electrical pulses detected by the sensors, and that an arithmetic unit is provided that co-operates with the comparator and is adapted to carry out the method in accordance with one of the claims 1-5.

8.  An apparatus according to claim 7, **characterised in that** a band-pass filter is connected with each of the sensors, to condition the electrical pulses detected by the sensors.

9. An apparatus according to claim 8, **characterised in that** the band-pass filter has a central frequency of approximately 1.2 Mhz and a band width of approximately 2 Mhz.

10. An apparatus according to one of the claims 7-9, **characterised in that** the same comprises a computer, which together with software according to claim 6, is equipped to implement the method in accordance with one of the claims 1-5.

11. An electrical machine, such as a generator or a motor for the generation and/or the use of electrical energy comprising a rotor and a stator, **characterised in that** an apparatus according to one of the claims 7-10 is connected to the stator.

**Patentansprüche**

1. Verfahren zur Lokalisierung des Ursprungs der Entladung von mindestens einer teilweisen Entladung im Stator einer elektrischen Maschine, wobei der Stator an verschiedenen Positionen mit Sensoren ausgestattet ist, um elektrische Impulse zu detektieren, die von der Entladung erzeugt werden, wobei zwischen den durch die Sensoren detektierten elektrischen Impulsen mindestens eine Zeitverzögerung ermittelt wird und basierend auf dieser mindestens einen Zeitverzögerung der Ort des Ursprungs der Entladung errechnet wird, **dadurch gekennzeichnet, dass** die Errechnung des Ortes des Ursprungs der Entladung durchgeführt wird, indem eine Differentialfunktion

$$e = \sqrt{\sum_{s=1}^{6} a_s \cdot (\Delta Tm_s - \Delta Tc_s)^2}$$

auf einen Mindestwert optimiert wird, wobei die verwendeten Variablen folgende Bedeutung haben:

e = Ergebnis der Differentialfunktion
s = Sensor A, B, C, D, E, F oder G
As = gemessene Amplitude des elektrischen Impulses am Sensor s
$\Delta$Tms = gemessene Zeitverzögerung am Sensor s in Bezug auf eine Referenz
$\Delta$Tcs = errechnete Zeitverzögerung am Sensor s in Bezug auf eine Referenz

und dass die errechnete Zeitverzögerung $\Delta$Tcs für verschiedene ausgewählte errechnete Orte der Entladung ermittelt wird und der den niedrigsten Wert der Differentialgleichung erzeugende ausgewählte errechnete Ort als Ursprung der Entladung bestimmt wird.

2. Verfahren nach Anspruch 1, **dadurch gekennzeichnet, dass** die Zeitverzögerung $\Delta$Tcs errechnet wird unter Verwendung der Formel:

$$T_s = \sqrt{\left(\frac{dist(x_p, x_s)}{v_x}\right)^2 + \left(\frac{dist(y_p, y_s)}{v_y}\right)^2} + c$$

wobei die verwendeten Variablen folgende Bedeutung haben:
dist (xp, xs) = Entfernung in tangentialer Richtung x des Stators zwischen dem Ursprung der Entladung (xp, yp) und dem Ort (xs, ys) des Sensors s
dist ((yp, ys) = Entfernung in axialer Richtung y des Stators zwischen dem Ursprung der Entladung (xp, yp) und dem Ort (xs, ys) des Sensors s
Vx = Ausbreitungsgeschwindigkeit des elektrischen Impulses in tangentialer Richtung x
Vy = Ausbreitungsgeschwindigkeit des elektrischen Impulses in axialer Richtung y
C = Korrekturkonstante
wobei xp und yp frei wählbare Variablen sind die sich auf den Ursprung der Entladung beziehen.

3.  Verfahren nach Anspruch 1 oder 2, **dadurch gekennzeichnet, dass** auch von der Ausbreitungsgeschwindigkeit Vx in tangentialer Richtung des Stators und von der Ausbreitungsgeschwindigkeit Vy in axialer Richtung des Stators als frei wählbare Variable Gebrauch gemacht wird, wenn die Zeitverzögerung ΔTcs für verschiedene ausgewählte errechnete Orte (xp, yp) errechnet wird.

4.  Verfahren nach einem der vorherigen Ansprüche, **dadurch gekennzeichnet, dass** ein Bandpassfilter mit jedem der Sensoren verbunden ist, um die von den Sensoren detektierten elektrischen Impulse aufzubereiten.

5.  Verfahren nach Anspruch 4, **dadurch gekennzeichnet, dass** das Bandpassfilter abgestimmt ist auf eine Mittenfrequenz von etwa 1,2 MHz und eine Bandbreite von etwa 2 MHz.

6.  Software, optional auf einem Träger, zur Durchführung des Verfahrens gemäß einem der Ansprüche 1 bis 5.

7.  Vorrichtung zur Lokalisierung des Ursprungs der Entladung von mindestens einer teilweisen Entladung im Stator einer elektrischen Maschine, wobei der Stator an verschiedenen Positionen mit Sensoren ausgestattet ist, um elektrische Impulse zu detektieren, die von der Entladung erzeugt werden,
    **dadurch gekennzeichnet, dass** selbige einen Komparator zur Bestimmung einer Zeitverzögerung zwischen den von den Sensoren detektierten elektrischen Impulsen aufweist und dass diese eine arithmetische Baugruppe aufweist, die mit dem Komparator zusammenarbeitet und geeignet ist, das Verfahren gemäß einem der Ansprüche 1 bis 5 auszuführen.

8.  Vorrichtung nach Anspruch 7, **dadurch gekennzeichnet, dass** ein Bandpassfilter mit jedem der Sensoren verbunden ist, um die von den Sensoren detektierten elektrischen Impulse aufzubereiten.

9.  Vorrichtung nach Anspruch 8, **dadurch gekennzeichnet, dass** das Bandpassfilter abgestimmt ist auf eine Mittenfrequenz von etwa 1,2 MHz und eine Bandbreite von etwa 2 MHz.

10. Vorrichtung nach einem der Ansprüche 7 bis 9, **dadurch gekennzeichnet, dass** diese einen Computer aufweist, der zusammen mit der Software nach Anspruch 6 dazu ausgerüstet ist, das Verfahren in Übereinstimmung mit einem der Ansprüche 1 bis 5 umzusetzen.

11. Einen Rotor und einen Stator aufweisende elektrische Maschine, wie beispielsweise ein Generator oder ein Motor für die Erzeugung und/oder den Verbrauch von elektrischer Energie,
    **dadurch gekennzeichnet, dass** eine Vorrichtung nach einem der Ansprüche 7 bis 10 mit dem Stator verbunden ist.

## Revendications

1.  Procédé destiné à localiser une source de décharge d'au moins une décharge partielle dans un stator d'une machine électrique, dans lequel le stator est pourvu sur diverses positions de capteurs destinés à détecter des impulsions électriques générées par la décharge, moyennant quoi au moins un délai temporel est déterminé entre les impulsions électriques détectées par les capteurs, et en se basant sur ce au moins un délai temporel est calculée la localisation de la source de décharge, **caractérisé en ce que** la localisation calculée de la source de décharge est effectuée en optimisant une fonction différentielle sur une valeur minimale :

$$e = \sqrt{\sum_{s=A}^{G} a_s.(\Delta Tm_s - \Delta Tc_s)^2}$$

dans laquelle les variables utilisées ont la signification suivante:
e = résultat de la fonction différentielle
s = capteur A, B, C, D, E, F ou G
As = amplitude mesurée de l'impulsion électrique au capteur s
Δ Tms = délai temporel mesuré au capteur s par rapport à une référence
Δ Tcs = délai temporel calculé au capteur s par rapport à la référence
et **en ce que** le délai temporel calculé Δ Tcs est déterminé pour différentes localisations calculées sélectionnées de la décharge, et la localisation calculée sélectionnée produisant la valeur de la fonction différentielle la plus basse est désignée comme source de décharge.

2. Procédé selon la revendication 1, **caractérisé en ce que** le délai temporel Δ Tcs est calculé en utilisant la formule :

$$T_s = \sqrt{\left(\frac{dist(xp, xs)}{V_x}\right)^2 + \left(\frac{dist(yp, ys)}{V_y}\right)^2} + c$$

dans laquelle les variables utilisées ont la signification suivante :
dist (xp, xs) = distance dans la direction tangentielle x du stator entre la source de décharge (xp, yp) et la localisation (xs, ys) du capteur s
dist (yp, ys) = distance dans la direction axiale y du stator entre la source de décharge (xp, yp) et la localisation (xs, ys) du capteur s
Vx = vitesse de propagation de l'impulsion électrique dans la direction tangentielle x
Vy = vitesse de propagation de l'impulsion électrique dans la direction axiale y
C = constante de correction ;
dans laquelle xp et yp sont des variables librement sélectionnables concernant la source de décharge.

3. Procédé selon la revendication 1 ou 2, **caractérisé en ce que** lors du calcul du délai temporel Δ Tcs pour diverses localisations calculées sélectionnées (xp, yp) de décharge, on utilise également la vitesse de propagation Vx dans la direction tangentielle du stator, et la vitesse de propagation Vy dans la direction axiale du stator comme variables librement sélectionnables.

4. Procédé selon l'une quelconque des revendications précédentes, **caractérisé en ce qu'**un filtre passe-bande est connecté à chacun des capteurs, pour conditionner les impulsions électriques détectées par les capteurs.

5. Procédé selon la revendication 4, **caractérisé en ce que** le filtre passe-bande est réglé à une fréquence centrale d'approximativement 1,2 Mhz et une bande passante d'approximativement 2 Mhz.

6. Logiciel, de façon optionnelle sur un support, destiné à effectuer le procédé conformément aux revendications 1 à 5.

7. Appareil destiné à localiser une source de décharge d'au moins une décharge partielle dans un stator d'une machine électrique, dans lequel le stator est muni sur diverses positions de capteurs destinés à détecter des impulsions électriques générées par la décharge, **caractérisé en ce que** ledit appareil possède un comparateur destiné à déterminer un délai temporel entre les impulsions électriques détectées par les capteurs, et **en ce qu'**une unité arithmétique est prévue qui coopère avec le comparateur et est adaptée pour effectuer le procédé conformément à l'une des revendications 1 à 5.

8. Appareil selon la revendication 7, **caractérisé en ce qu'**un filtre passe-bande est connecté avec chacun des capteurs, pour conditionner les impulsions électriques détectées par les capteurs.

9. Appareil selon la revendication 8, **caractérisé en ce que** le filtre passe-bande a une fréquence centrale d'approximativement 1,2 Mhz et une bande passante d'approximativement 2 Mhz.

10. Appareil selon l'une des revendications 7 à 9, **caractérisé en ce que** ledit appareil comprend un ordinateur, qui conjointement avec le logiciel selon la revendication 6, est équipé pour mettre en oeuvre le procédé conformément à l'une des revendications 1 à 5.

11. Machine électrique, tel qu'un générateur ou un moteur pour la génération et/ou l'utilisation d'énergie électrique comprenant un rotor et un stator, **caractérisée en ce qu'**un appareil selon l'une des revendications 7 à 10 est connecté au stator.

**FIG. 1**

**FIG. 2**

**FIG. 3**